# EUROPEAN PATENT APPLICATION

(11) **EP 4 345 925 A1**
(43) Date of publication of application: **03.04.2024**
(21) Application number: 23167343.5
(22) Date of filing: 11.04.2023
(51) Int. Cl.: H01L 33/16, H01L 33/50

(54) **LIGHT EMITTING DEVICE, DISPLAY APPARATUS INCLUDING THE SAME AND MANUFACTURING METHOD OF THE LIGHT EMITTING DEVICE**

(30) Priority: 29.09.2022 KR 20220124652
(71) Applicant: Samsung Electronics Co., Ltd., Suwon-si, Gyeonggi-do 16677 (KR)
(72) Inventor: CHOI, Junhee, 16678, Suwon-si, (KR); KONG, Kiho, 16678, Suwon-si, (KR); KIM, Joosung, 16678, Suwon-si, (KR); LEE, Eunsung, 16678, Suwon-si, (KR); HAN, Joohun, 16678, Suwon-si, (KR)
(74) Representative: Elkington and Fife LLP

(57) **Abstract**

A light emitting device includes a light emitting rod in which a porous first type semiconductor layer, an active layer, and a second type semiconductor layer are sequentially arranged, and a wavelength conversion cluster is embedded in the porous first type semiconductor layer and configured to convert a first light generated in the active layer into a second light having a different wavelength.

## Description

### FIELD OF THE INVENTION

The disclosure relates to a light emitting device, a display device including the light emitting device, and a manufacturing method of the light emitting device.

### BACKGROUND OF THE INVENTION

A light emitting device is known as a next-generation light source having advantages such as long lifespan, low power consumption, fast response speed, environmental friendliness, etc. compared to other light sources. Light emitting devices are used in various products as light sources including backlights of display devices, etc. In particular, Group III nitride-based light emitting diodes (LEDs) such as gallium nitride (GaN), aluminum gallium nitride (AlGaN), indium gallium nitride (InGaN), indium aluminum gallium nitride (InAlGaN), etc. serve as semiconductor light emitting devices that output light.

### SUMMARY OF THE INVENTION

Apparatus and methods consistent with this disclosure relate to light emitting devices capable of emitting light of a wavelength different from that of light generated in an active layer, and a display device including the light emitting device.

Additional aspects will be set forth in part in the description which follows and, in part, will be apparent from the description, or may be learned by practice of example embodiments of the disclosure.

According to an aspect of the disclosure, a light emitting device includes a light emitting rod including a porous first type semiconductor layer, an active layer, and a second type semiconductor layer which are sequentially arranged, and a wavelength conversion cluster embedded in the porous first type semiconductor layer, the wavelength conversion cluster being configured to convert a first light generated in the active layer into a second light having a different wavelength.

The wavelength conversion cluster may include quantum dots converting the first light into the second light, and the quantum dots may be disposed in pores included in the porous first type semiconductor layer.

A proportion of the quantum dots in the pores may be equal to or greater than about 80% of space in the pores.

The light emitting device may further include a wavelength selective transmission layer disposed on a side surface of the light emitting rod, the wavelength selective transmission layer being configured to reflect incident first light into the light emitting rod, and transmit incident second light to an outside of the light emitting rod.

The wavelength selective transmission layer may include a distributed Bragg reflector.

The light emitting device may further include a reflective layer disposed on at least one of an upper surface or a lower surface of the light emitting rod, the reflective layer being configured to reflect the first light and the second light into the light emitting rod.

The reflective layer may include a conductive material.

The reflective layer includes a metal material.

The light emitting device may further include a wavelength conversion layer disposed on a side surface of the light emitting rod and configured to convert the first light into the second light.

A volume of the porous first type semiconductor layer may be greater than at least one of: a volume of the active layer and a volume of the second type semiconductor layer.

The porous first type semiconductor layer may include an n-type semiconductor material, and the second type semiconductor layer may include a p-type semiconductor material.

The second light may have a longer wavelength than that of the first light.

A wavelength of the first light may be equal to or greater than about 300 nm and equal to or less than about 500 nm.

A wavelength of the second light may be equal to or greater than about 490 nm and equal to or less than about 780 nm.

The wavelength conversion cluster may be further embedded in at least one of: the active layer and the second type semiconductor layer.

The light emitting device may further include a first electrode electrically connected to the porous first type semiconductor layer, and a second electrode electrically connected to the second type semiconductor layer, and at least one of: the first electrode and the second electrode may be a reflective electrode.

According to another aspect of the disclosure, a display device includes a display device layer including a plurality of light emitting devices, and a driving device layer including a plurality of transistors electrically connected to the plurality of light emitting devices respectively and configured to drive the plurality of light emitting devices, the plurality of light emitting devices include a first light emitting device configured to emit a first light and a second light emitting device configured to emit a second light having a different wavelength from that of the first light, and wherein the first light emitting device and the second light emitting device each may include an active layer generating the first light.

The second light emitting device may further include a porous semiconductor layer, and a wavelength conversion cluster embedded in the porous semiconductor layer and configured to convert the first light into the second light.

The first light may be light within a range of an ultraviolet light to a blue light, and the second light may be light within a range of a green light to a red light.

According to another aspect of the disclosure, a manufacturing method of a light emitting device includes sequentially forming a first type semiconductor layer, an active layer, and a second type semiconductor layer on a substrate, making the first type semiconductor layer porous, and forming a wavelength conversion cluster including quantum dots in the porous first type semiconductor layer.

### BRIEF DESCRIPTION OF THE DRAWINGS

The above and other aspects, features, and advantages of example embodiments of the disclosure will be more apparent from the following description taken in conjunction with the accompanying drawings, in which:
FIG. 1 is a cross-sectional view illustrating a light emitting diode (LED) according to an embodiment;
FIGS. 2A to 2E are reference diagrams illustrating a method of manufacturing the LED according to an embodiment;
FIG. 3 is a diagram illustrating a light emitting device including the LED according to an embodiment;
FIG. 4 is a diagram illustrating a LED including a porous second type semiconductor layer according to an embodiment;
FIG. 5 is a diagram illustrating a LED including a wavelength conversion layer according to an embodiment;
FIG. 6 is a diagram illustrating a LED including a wavelength conversion layer according to another embodiment;
FIG. 7 is a diagram illustrating a LED including a wavelength conversion layer according to another embodiment;
FIG. 8 is a diagram illustrating a LED including a wavelength conversion layer according to another embodiment;
FIG. 9 is a diagram illustrating a LED including a plurality of reflective layers according to an embodiment;
FIG. 10 is a diagram illustrating a LED including a wavelength conversion cluster according to an embodiment;
FIG. 11 is a diagram illustrating a LED mitting light of multiple wavelengths according to an embodiment;
FIG. 12 is a diagram illustrating a part of a display device including a nitride semiconductor layer according to an embodiment;
FIG. 13 is a diagram illustrating a part of a display device according to another embodiment; and
FIG. 14 is a diagram illustrating a part of a display device according to another embodiment.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments will be described with reference to the accompanying drawings. In the drawings, like reference numerals refer to like elements, and the sizes of elements may be exaggerated for clarity of illustration. Example embodiments described herein are for illustrative purposes only, and various modifications may be made therein.

In the following description, when an element is referred to as being "above" or "on" another element, it may be directly on an upper, lower, left, or right side of the other element while making contact with (i.e. contacting) the other element or may be above an upper, lower, left, or right side of the other element without making contact with the other element. The terms of a singular form may include plural forms unless otherwise stated. It will be further understood that the terms "comprises" and/or "comprising" used herein specify the presence of stated features or elements, but do not preclude the presence or addition of one or more other features or elements.

An element referred to with the definite article or a demonstrative pronoun may be construed as the element or the elements even though it has a singular form. Operations of a method may be performed in any appropriate order unless explicitly described in terms of order or described to the contrary, and are not limited to the stated order thereof.

Also, terms such as "unit" or "module" used herein may be used to denote a unit that has at least one function or operation and is implemented with hardware such as a processor, software, or a combination of hardware and software.

Furthermore, line connections or connection members between elements depicted in the drawings represent functional connections and/or physical or circuit connections by way of example. In actual applications, they may be replaced or embodied with various additional functional connections, physical connections, or circuit connections.

All examples or exemplary terms are used herein to describe technical ideas and should not be considered for purposes of limitation unless defined by the claims.

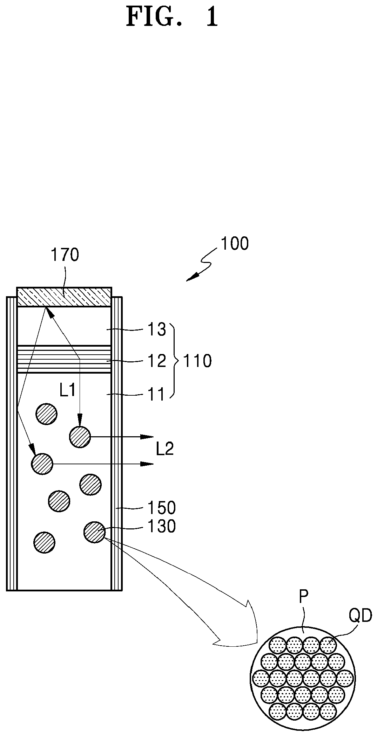

FIG. 1 is a cross-sectional view illustrating a light emitting diode (LED) 100 according to an embodiment. As shown in FIG. 1, the LED 100 is made of an inorganic-based semiconductor material, and may emit light of a specific wavelength according to a material included in the LED 100.

The LED 100 may include various types of LEDs of micro- or nano-scale size. For example, the width or diameter of the LED 100 may be equal to or less than about 100 µm, or may be equal to or less than 50 µm. The LED 100 may include a light emitting diode (LED), a vertical-cavity surface-emitting laser (VCSEL), etc.

The LED 100 may include a light emitting rod 110 in which a first type semiconductor layer 11, an active layer 12, and a second type semiconductor layer 13 are sequentially arranged. The first type semiconductor layer 11 and the second type semiconductor layer 13 may be spaced apart from each other, and the active layer 12 may be disposed between the first type semiconductor layer 11 and the second type semiconductor layer 13. The light emitting rod 110 may have a rod shape with a length greater than a width. For example, the ratio of the length of the light emitting rod 110 to the width thereof may be equal to or greater than about 3 times. The volume of the first type semiconductor layer 11 may be greater than the volume of the active layer 12 or the volume of the second type semiconductor layer 13. Alternatively, the volume of the first type semiconductor layer 11 may be equal to or greater than the sum of the volume of the active layer 12 and the volume of the second type semiconductor layer 13.

The first type semiconductor layer 11 may be a semiconductor layer doped with a first type conductivity. For example, the first type semiconductor layer 11 may be an n-type semiconductor. For example, the first type semiconductor layer 11 may include n-GaN. However, the disclosure is not necessarily limited thereto, and in some cases, the first type semiconductor layer 11 may include a p-type semiconductor. The first type semiconductor layer 11 may have a single-layer or multi-layer structure. The first type semiconductor layer 11 may include, for example, InAlGaN, GaN, AlGaN, and/or InGaN, and may include a semiconductor layer doped with a type of conductivity such as Si, Ge, Sn, etc.

The first type semiconductor layer 11 may be porous. Pores P included in the first type semiconductor layer 11 are spaces in the first type semiconductor layer 11Neighboring pores P may or may not be connected to each other. The size of each of the pores P may vary. For example, the size of each of the pores P may be equal to or greater than about 1 nm and equal to or smaller than about 1 µm. The size of each of the pores P may be equal to or greater than about 10 nm and equal to or smaller than about 500 nm. The pores P may be formed by an electrochemical wet etching method, etc. The size or density of each of the pores P may be adjusted by voltage, time, electrolyte, concentration, etc. applied to the electrochemical wet etching method.

The porosity of the first type semiconductor layer 11 may be defined as the volume of the pores P with respect to the total volume of the first type semiconductor layer 11. The porosity of the first type semiconductor layer 11 may be equal to or greater than about 10%, equal to or greater than about 20%, equal to or smaller than about 40%, or equal to or smaller than about 80%. A too large porosity may result in difficulty in the carrier movement of the first type semiconductor layer 11, and a too small porosity may result in difficulty in the wavelength conversion of a wavelength conversion cluster 130 to be described below due to the low density of the wavelength conversion cluster 130.

The second type semiconductor layer 13 may be a semiconductor layer doped with a second type conductivity different from the first type conductivity. For example, the second type semiconductor layer 13 may include a p-type semiconductor. The second type semiconductor layer 13 may include the Group III-V p-type semiconductor, for example, p-GaN. The second type semiconductor layer 13 may have a single-layer or multi-layer structure. For example, the second type semiconductor layer 13 may include a semiconductor material of any one of InAlGaN, GaN, AlGaN, InGaN, AIN, and InN, and may be a semiconductor layer doped with a conductive dopant such as Mg.

The active layer 12 may be disposed between the first type semiconductor layer 11 and the second type semiconductor layer 13. The active layer 12 may generate light through combinations of electrons and holes, and may have a multi-quantum well (MQW) structure or a single-quantum well (SQW) structure. The active layer 12 may include the Group III-V semiconductor, for example, InGaN, GaN, AlGaN, AlInGaN, etc. A clad layer (not shown) doped with a conductive dopant may be formed on the upper portion and/or the lower portion of the active layer 12. For example, the clad layer may be implemented as an AlGaN layer or an InAlGaN layer.

The light emitting rod 110 may further include a clad layer and/or electrode on the upper portion and/or the lower portion of each of the first type semiconductor layer 11, the active layer 12, and the second type semiconductor layer 13.

The wavelength of light emitted from the active layer 12 may vary depending on the content of a material of the active layer 12. As the content of indium (In) of the active layer 12 increases, the wavelength of the light emitted from the active layer 12 may increase. For example, when the content of indium (In) of the active layer 12 is about 15%, the active layer 12 may emit blue light of about 450 nm, and when the content of indium (In) of the active layer 12 is about 25%, the active layer 12 may emit green light of about 520 nm. In addition, when the content of indium (In) of the active layer 12 is about 35%, the active layer 12 may emit red light of about 630 nm.

In general, an LED equal to or greater than about 100 µm x 100 µm has high optical efficiency. However, as the size of the LED is reduced to be equal to or smaller than 100 µm, the light efficiency may be rapidly reduced. When the active layer 12 including AlGaInP emits red light, external quantum efficiency (EQE) may be rapidly reduced. For example, because the active layer 12 that generates red light of about 630 nm has the content of indium (In) of 35%, due to a defect caused by a lattice mismatch between the active layer 12 and the first type semiconductor layer 11, the EQE is expected to be equal to less than 5%. In addition, when the active layer 12 includes InGaN, a blue shift phenomenon may also occur due to an increase in current. Such a blue shift is due to the quantum stark effect according to the piezoelectric field. In addition, a full width at half maximum (FWHM) issue may exist due to the agglomeration of indium (In).

The content of indium (In) of the active layer 12 according to an embodiment may be equal to or smaller than about 25%. For example, the content of indium (In) of the active layer 12 may be equal to or smaller than about 15%, and the active layer 12 may generate blue light ultraviolet to blue light, or light having a wavelength equal to or greater than about 300 nm and equal to or less than 500 nm. The content of indium (In) of the active layer 12 is small, which may reduce the occurrence of the defect caused by the lattice mismatch between the first type semiconductor layer 11 and the active layer 12. In addition, the small content of indium (In) may also reduce the blue shift phenomenon.

The active layer 12 of the LED 100 according to an embodiment may include a nitride semiconductor based on InGaN. In the case of the LED 100 with the narrow width compared to the length, when the nitride semiconductor based on InGaN is used as the active layer 12, the surface leakage current may be reduced compared to the active layer 12 using a nitride semiconductor based on AlGaInP.

The LED 100 according to an embodiment may further include the wavelength conversion cluster 130 embedded in the light emitting rod 110 and converting the light generated from the active layer 12 into light having a different wavelength. The wavelength conversion cluster 130 may be disposed in the porous first type semiconductor layer 11. For example, the wavelength conversion cluster 130 may be disposed in the pores P included in the first type semiconductor layer 11.

The active layer 12 may generate a first light L1 in the range of ultraviolet to blue light, and the wavelength conversion cluster 130 may convert the first light L1 into a second light L2 having a different wavelength. The second light L2 may have a wavelength greater than that of the first light L1. The second light L2 may be green light, red light, or light having a wavelength equal to or greater than about 490 nm and equal to or less than 780 nm. As described above, the active layer 12 needs a high content of indium (In) to generate blue light, but the high content of indium (In) deteriorates light efficiency.

The LED 100 according to an embodiment may use the active layer 12 with a low content of indium (In) while the wavelength conversion cluster 130 embedded in the light emitting rod 110 may convert the light generated from the active layer 12 into red light or green light.

The wavelength conversion cluster 130 may include a plurality of quantum dots (QDs). Among the plurality of QDs, neighboring QDs may or may not be connected to each other. The plurality of QDs are connected to each other or are not connected to each other and arranged in groups in the pores P of the first type semiconductor layer 11, and is referred to as a cluster. The connected QDs may be ligand-bound. The proportion of the QDs in the pores P may be equal to or greater than about 80% or about 90%. A space other than the QDs in the pores P may be an empty space and may be filled with a photoresist material.

A QD is an inorganic material having a size of several nm, and has an energy bandgap of a specific wavelength. When adsorbing light having energy higher than the energy bandgap, the QD may emit light of a different wavelength. The QD may have a narrow emission wavelength band.

The QD may have a core-shell structure having a core portion and a shell portion, or may have a particle structure without a shell. The core-shell structure may be a single-shell or multi-shell structure, such as a double-shell structure.

The QD may include the Group II-VI semiconductor, the Group III-V semiconductor, the Group IV-VI semiconductor, the Group IV semiconductor, and/or graphene QD. The QD may include, for example, Cd, Se, Zn, S and/or InP, and may have a diameter equal to or smaller than several tens of nm, for example, equal to or smaller than about 10 nm. The QD may emit blue light according to the material or size thereof or may be excited by ultraviolet light to emit red light or green light.

The LED 100 may further include a wavelength selective transmission layer 150 disposed on the side surface of the light emitting rod 110. The wavelength selective transmission layer 150 may surround at least a part of the side surface of the light emitting rod 110. The wavelength selective transmission layer 150 may transmit only light of a specific wavelength among incident light. For example, the wavelength selective transmission layer 150 may reflect the first light L1 generated in the active layer 12 among the incident light, to the light emitting rod 110, and transmit the second light L2 of which wavelength is converted by the wavelength conversion cluster 130 to the outside. Thus, the LED 100 may emit light of which wavelength is converted by the wavelength conversion cluster 130 rather than the light generated in the active layer 12. The active layer 12 may generate blue light or ultraviolet light, while the LED 100 may emit blue light or green light.

The wavelength selective transmission layer 150 may recycle the incident first light L1 so as to be converted into the second light L2 by the wavelength conversion cluster 130 by reflecting the first light L1 to the light emitting rod 110, and may increase the color purity of the light emitted by the LED 100 by emitting the incident second light L2 to the outside of the LED 100.

The wavelength selective transmission layer 150 may include a distributed Bragg reflector. For example, the wavelength selective transmission layer 150 may include two layers having different refractive indices. The two layers may be stacked alternately and repeatedly. Due to a difference in refractive index of the two layers, light may be reflected from the interface of each layer, and the reflected light may cause interference. Each of the two layers may include silicon (Si), silicon nitride (Si₃N₄), silicon oxide (SiO₂), titanium oxide (TiO₂), etc. For example, one layer may be made of titanium (TiO₂), and the other layer may be made of silicon oxide (SiO₂). The reflectance of the wavelength selective transmission layer 150 with respect to the first light L1 and the transmittance thereof with respect to the second light L2 may be designed by adjusting the thickness and/or the number of stacking of the two layers,

The LED 100 may further include a reflective layer 170 disposed on the end of the light emitting rod 110. The reflective layer 170 may be disposed on the upper surface of the light emitting rod 110, that is, the second type semiconductor layer 13. The reflective layer 170 may reflect incident light to the light emitting rod 110. For example, the reflective layer 170 may reflect the incident first light L1 and/or the second light L2 into the light emitting rod 110. The reflective layer 170 may reflect the first light L1 into the light emitting rod 110 so that the first light L1 is converted into the second light L2 by the wavelength conversion cluster 130, and thus, the color conversion rate may be increased. The reflective layer 170 may reflect the second light L2 into the light emitting rod 110 so that the second light L2 is emitted to the outside through the wavelength selective transmission layer 150, and thus, the emission direction of the second light L2 may be controlled.

The reflective layer 170 may be made of a material having high reflectivity with respect to the first light L1 and the second light L2. The reflective layer 170 disposed on the second type semiconductor layer 13 may be made of a conductive material capable of electrically connecting the reflective layer 170 to an electrode to be described below. The reflective layer 170 may include a metal material having high reflectance and conductivity, for example, Ag, Au, Pt, Ni, Cr, and/or Al, but is not limited thereto.

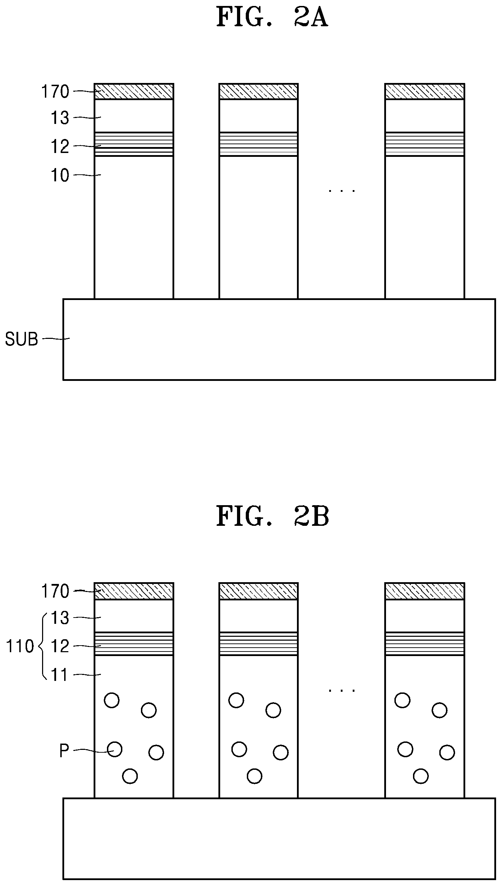

FIGS. 2A to 2E are reference diagrams illustrating a method of manufacturing the LED 100 according to an embodiment.

First, as shown in FIG. 2A, the first type semiconductor layer 11, the active layer 12, and the second type semiconductor layer 13 may be sequentially formed on a base substrate SUB. The base substrate SUB may be a substrate growing the LED 100. The base substrate SUB may include various materials used in a general semiconductor process. For example, a silicon substrate or a sapphire substrate may be used as the base substrate SUB.

The first type semiconductor layer 11, the active layer 12, and the second type semiconductor layer 13 may be formed by using metal organic chemical vapor deposition (MOCVD), chemical vapor deposition (CVD), plasma-enhanced chemical vapor deposition (PECVD), molecular beam growth (MBE), hydride vapor phase epitaxy (HVPE), etc.

The reflective layer 170 may be formed on the second type semiconductor layer 13. The reflective layer 170 may be formed using MOCVD, CVD, PECVD, etc.

As shown in FIG. 2B, the light emitting rod 110 may be formed by forming the pores P in the first type semiconductor layer 11. The pores P of the first type semiconductor layer 11 may be formed by using an electrochemical wet etching method. The electrochemical wet etching method may include an etching method using a potential difference or a photoelectrochemical etching method. An etching solution may include, but is not limited to, oxalic acid, nitric acid, sodium nitrate, etc.

The density of the pores P of the first type semiconductor layer 11, that is, the porosity, may be adjusted by the voltage applied in the pore making process, the pore making time, the etching solution used in the pore making process, and the doping concentration of the first type semiconductor layer 11. For example, when the first type semiconductor layer 11 is made porous by etching Si included in the first type semiconductor layer 11, the higher the doping concentration of Si, the higher the porosity of the first type semiconductor layer 11. When the active layer 12 and the second type semiconductor layer 13 are not doped with Si, the active layer 12 and the second type semiconductor layer 13 may not be made porous.

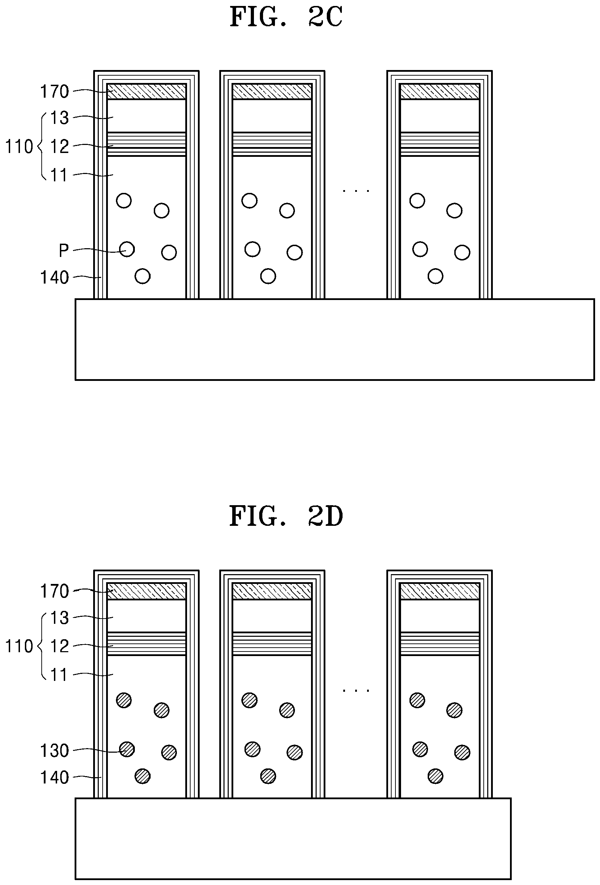

As shown in FIG. 2C, an insulating layer 140 may be formed on the light emitting rod 110. The insulating layer 140 may be made of the same material as the wavelength selective transmission layer 150 shown in FIG. 1. The insulating layer 140 may be formed to cover all of exposed regions of the light emitting rod 110 and the reflective layer 170. For example, the insulating layer 140 may be formed to cover the side surface of the light emitting rod 110 and the upper surface and side surfaces of the reflective layer 170.

As shown in FIG. 2D, the wavelength conversion cluster 130 may be formed in the light emitting rod 110. By immersing the light emitting rod 110 in a solution containing QDs and performing an electrolytic plating method, a photoresist process, an electrophoretic deposition method on the light emitting rod 110, etc., QDs may enter and be embedded in the light emitting rod 110. QDs may enter the porous first type semiconductor layer 11 and be disposed in the pores P of the first type semiconductor layer 11. Among the QDs disposed in the pores P of the first type semiconductor layer 11, neighboring QDs may or may not be connected to each other, and arranged in groups in the pores P, and are referred to as a cluster. QDs connected to each other may be ligand-bound. The proportion of QDs in the pores P may be equal to or greater than about 80% or equal to or less than about 90% in terms of occupancy of the pore space. A space other than QDs in the pores P may be an empty space and may be filled with a photoresist material. After QDs enter the pores P, a solvent may be removed, and the photoresist material may remain.

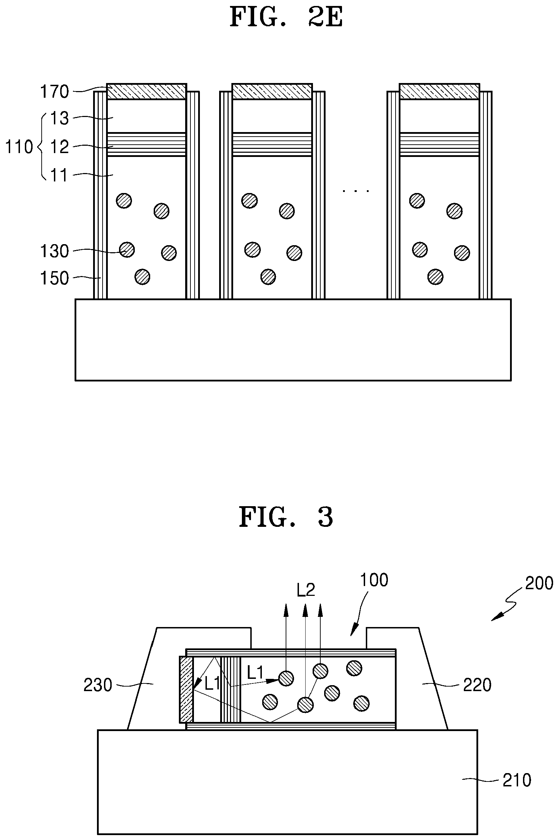

As shown in FIG. 2E, the wavelength selective transmission layer 150 may be formed by etching a partial region of the insulating layer 140. Thereafter, the LED 100 may be separated from the base substrate SUB and transferred to another substrate, for example, a substrate including a transistor.

FIG. 3 is a diagram illustrating a light emitting device 200 including the LED 100 according to an embodiment. As shown in FIG. 3, the light emitting device 200 may include a substrate 210, the LED 100 disposed on the substrate 210, and first and second electrodes 220 and 230 in contact with the LED 100.

The substrate 210 may be a semiconductor substrate. For example, the substrate 210 may include a Group IV semiconductor material, a Group III/V semiconductor compound, or a Group II/VI semiconductor compound. As a specific example, the substrate 210 may include Si, Ge, SiC, SiGe, SiGeC, Ge Alloy, GaAs, InAs, InP, etc. However, this is only an example, and other various semiconductor materials may be used as the substrate 210.

The substrate 210 may include a single layer or a plurality of layers in which different materials are stacked. The substrate 210 may include, for example, a silicon-on-insulator (SOI) substrate or a silicon germanium-on-insulator (SGOI) substrate. In addition, the substrate 210 may include a non-doped semiconductor material or a doped semiconductor material.

At least one semiconductor device may be included in the substrate 210. Here, the semiconductor device may include, for example, at least one of a transistor, a capacitor, a diode, or a resistor. However, the disclosure is not limited thereto. When the light emitting devices 200 and 100 operate as pixels of a display device, the substrate 210 may be a display panel including a transistor, etc.

The LED 100 may include the light emitting rod 110 including the first type semiconductor layer 11, the active layer 12, and the second type semiconductor layer 13, the wavelength conversion cluster 130 embedded in the light emitting rod 110, the wavelength selective transmission layer 150 disposed on the surface of the light emitting rod 110, and the reflective layer 170 shown in FIG. 1. Each component of the LED 100 has been described above, and thus, a detailed description thereof will be omitted.

The length direction of the LED 100 and the thickness direction of the substrate 210 may be perpendicular to each other. For example, as shown in FIG. 3, the side surface of the light emitting rod 110 may be disposed on the surface of the substrate 210. In the LED 100, the second light L2 converted in the light emitting rod 110 may be emitted in a direction parallel to the thickness direction of the substrate 210 through the wavelength selective transmission layer 150.

The first and second electrodes 220 and 230 may be disposed on the substrate 210. The first and second electrodes 220 and 230 may be spaced apart from each other with the LED 100 disposed therebetween, and the first electrode 220 may be electrically connected to the first type semiconductor layer 11, and the second electrode 230 may be electrically connected to the second type semiconductor layer 13. For example, the first electrode 220 may contact the first type semiconductor layer 11, and the second electrode 230 may contact the reflective layer 170. The reflective layer 170 is made of a conductive material, and the second electrode 230 may be electrically connected to the second type semiconductor layer 13 through the reflective layer 170.

The first and second electrodes 220 and 230 may cover a partial region of the wavelength selective transmission layer 150 while being disposed on the substrate 210. The first and second electrodes 220 and 230 are in contact with the wavelength selective transmission layer 150, and thus, the coupling force between the LED 100 and the first and second electrodes 220 and 230 may be increased. The first and second electrodes 220 and 230 may be disposed on the same plane and may have the same thickness. When the first and second electrodes 220 and 230 have the same thickness, the LED 100 may be more stably connected to the first and second electrodes 220 and 230.

The first electrode 220 may be a reflective electrode. The first electrode 220 may include at least one of metal materials having excellent conductivity, for example, Au, Ag, Cu, Zn, Al, In, Ti, Si, Ge, Sn, Mg, Ta, Cr, W, Ru, Rh, Ir., Ni, Pd, or Pt. The light transmittance of the first electrode 220 may be equal to or greater than about 80%. The first electrode 220 is the reflective electrode, and may prevent the first light L1 and/or the second light L2 from being emitted in a direction perpendicular to the thickness direction of the substrate 210 by reflecting the first light L1 and/or the second light L2 incident from the light emitting rod 110 to the light emitting rod 110. That is, the light emitting rod 110 may emit the second light L2 in the direction parallel to the thickness direction of the substrate 210 by the reflective layer 170 and the first electrode 220.

The second electrode 230 may be a transparent electrode. The second electrode 230 may include, for example, a transparent conductive material such as indium tin oxide (ITO), indium zinc oxide (IZO), etc. However, the disclosure is not limited thereto. The light transmittance of the second electrode 230 may be equal to or greater than about 80%. The reflective layer 170 is disposed on the second type semiconductor layer 13, and thus, the second electrode 230 may not be a transparent electrode. However, the disclosure is not limited thereto. The second electrode 230 may also be a reflective electrode. When the second electrode 230 is a reflective electrode, the reflective layer 170 may not be provided.

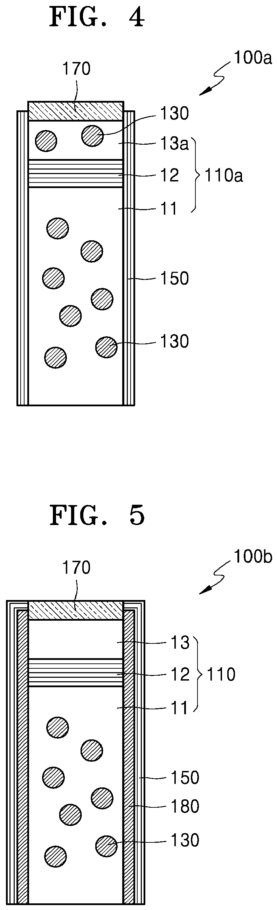

FIG. 4 is a diagram illustrating a LED 100a including a porous second type semiconductor layer 13a according to an embodiment. In the LED 100a of FIG. 4, the second type semiconductor layer 13a may also be porous, and the wavelength conversion cluster 130 may be embedded in the second type semiconductor layer 13a. The first type semiconductor layer 11 is also porous. The wavelength conversion cluster 130 is also embedded in the second type semiconductor layer 13a, and thus, the light conversion rate from the first light L1 to the second light L2 may be increased. Although not shown in the drawings, the active layer 12 may also be porous, and the wavelength conversion cluster 130 may also be embedded in the active layer 12.

FIG. 5 is a diagram illustrating a LED 100b including a wavelength conversion layer 180 according to an embodiment. The LED 100b of FIG. 5 may further include the wavelength conversion layer 180. The wavelength conversion layer 180 may be disposed between the light emitting rod 110 and the wavelength selective transmission layer 150. For example, the wavelength conversion layer 180 may surround the side surface of the light emitting rod 110. The wavelength conversion layer 180 may convert incident first light, for example, blue light or ultraviolet light, into second light having a different wavelength, for example, green light or red light. The LED 100 may emit the second light to the side surface thereof. The wavelength conversion layer 180 may include QDs like the wavelength conversion cluster 130. The wavelength of the converted light may vary depending on materials and sizes of QDs.

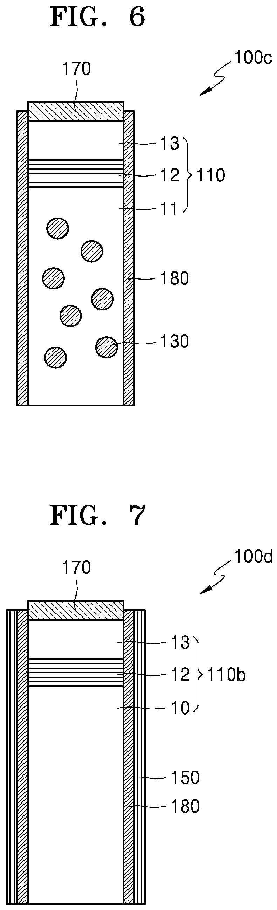

FIG. 6 is a diagram illustrating a LED 100c including the wavelength conversion layer 180 according to another embodiment. In the LED 100c of FIG. 6, only the wavelength conversion layer 180 may be disposed on the side surface of the light emitting rod 110 without a wavelength selective transmission layer. A first light generated in the active layer 12 may be almost wholly entirely converted into a second light in the wavelength conversion cluster 130 and the wavelength conversion layer 180. Thus, the wavelength selective transmission layer 150 may not be provided.

FIG. 7 is a diagram illustrating a LED 100d including the wavelength conversion layer 180 according to another embodiment. The LED 100d of FIG. 7 may include only the wavelength conversion layer 180 without including the wavelength conversion cluster 130. The first type semiconductor layer 10, the active layer 12, and the second type semiconductor layer 13 included in a light emitting rod 110b of FIG. 7 need not be porous. The wavelength conversion layer 180 may surround the side surface of the light emitting rod 110b. A first light generated in the active layer 12 may be converted into a second light in the wavelength conversion layer 180, and only the second light may transmit the wavelength selective transmission layer 150 and be emitted to the outside.

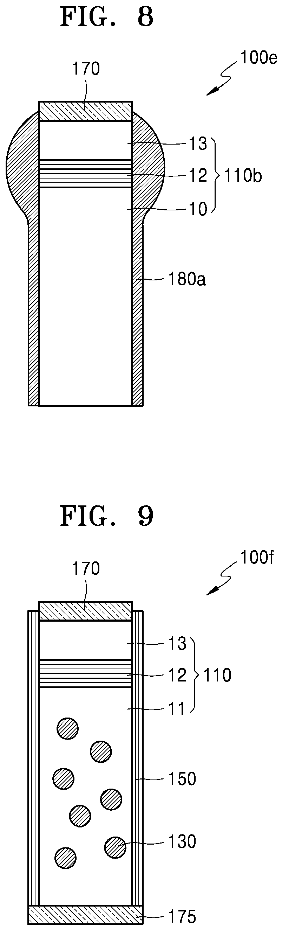

FIG. 8 is a diagram illustrating a LED 100e including a wavelength conversion layer 180a according to another embodiment. The LED 100e of FIG. 8 may include only the wavelength conversion layer 180a without including the wavelength conversion cluster 130. The first type semiconductor layer 10, the active layer 12, and the second type semiconductor layer 13 included in the light emitting rod 110b of FIG. 8 need not be porous. The wavelength conversion layer 180a may surround the side surface of the light emitting rod 110b. The thickness of the wavelength conversion layer 180a may vary. For example, the thickness of a region of the wavelength conversion layer 180a close to the active layer 12 may be thick, and the thickness of a region of the wavelength conversion layer 180a located away from the active layer 12 may be thin. Light emitted from the active layer 12 has a high emission density in a region of the light emitting rod 110b adjacent to the active layer 12. Accordingly, in the region of the wavelength conversion layer 180a close to the active layer 12, the thickness of the wavelength conversion layer 180 may be thick so that a large number of QDs are distributed.

FIG. 9 is a diagram illustrating a LED 100f including a plurality of reflective layers 170 and 175 according to an embodiment. The LED 100f of FIG. 9 may include the first reflective layer 170 disposed on an upper surface of the light emitting rod 110 and a second reflective layer 175 disposed on a lower surface of the light emitting rod 110. The first and second reflective layers 170 and 175 may be made of a material having a reflective characteristic with respect to light and a high conductivity. For example, the first and second reflective layers 170 and 175 may include, but are not limited to, Ag, Au, Pt, Ni, Cr, and/or Al. The LED 100f includes the first and second reflective layers 170 and 175, and thus, first and second electrodes included in the light emitting device 200 may be transparent electrodes.

Although not shown in the drawings, the LED 100 may not include the first reflective layer 170. When the LED 100 does not include the first reflective layer 170, the first and second electrodes of the light emitting device 200 may be reflective electrodes.

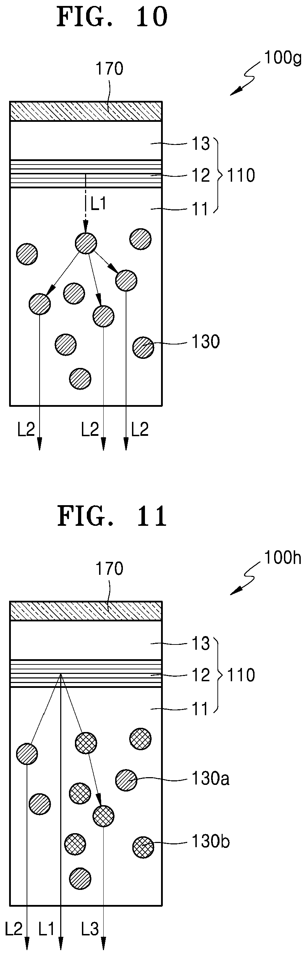

FIG. 10 is a diagram illustrating a LED 100g including the wavelength conversion cluster 130 according to an embodiment. The LED 100g of FIG. 10 may not include the wavelength selective transmission layer 150. When most of the first light L1 generated in the active layer 12 is converted into the second light L2 while traveling the first type semiconductor layer 11, the LED 100g may not include the wavelength selective transmission layer 150.

The LED 100g of FIG. 10 may be a vertical type LED. For example, the first light L1 generated in the active layer 12 may be converted into the second light L2 by the wavelength conversion cluster 130 while passing through the first type semiconductor layer 11. In addition, the converted second light L2 may be emitted to the outside in a direction parallel to the longitudinal direction of the light emitting rod 110. Although not shown in the drawings, a reflective layer is further disposed on the side surface of the LED 100g of FIG. 10, and thus, the directivity of the light emitted from the LED 100g may be increased.

FIG. 11 is a diagram illustrating a LED 100h emitting light of multiple wavelengths according to an embodiment. A first wavelength conversion cluster 130a that converts the first light L1 into the second light L2 having a different wavelength and a second wavelength conversion cluster 130b that converts the first light L1 into a third light L3 having a different wavelength from those of the first light L1 and the second light L2 may be embedded in the light emitting rod 110h of FIG. 11. The first light L1 may be blue or ultraviolet light, the second light L2 may be red light, and the third light L3 may be green light.

The LED 100h of FIG. 11 may be a vertical type LED. For example, while the first light L1 generated in the active layer 12 passes through the first type semiconductor layer 11, a part of the first light L1 may be converted into the second light L2 by a first wavelength conversion cluster 130a, another part of the first light L1 may be converted into the second light L2 by a second wavelength conversion cluster 130b, and the remaining first light L1 may not be converted. Thus, the first to third lights L1, L2, and L3 are emitted to the outside in a direction parallel to the longitudinal direction of the light emitting rod 110. White light may be emitted by this example. Although not shown in the drawings, a reflective layer is further disposed on the side surface of the LED 100h of FIG. 11, and thus, the directivity of the light emitted from the LED 100h may be increased.

The above-described LEDs 100, 100a, 100b, 100c, 100d, 100e, 100f, 100g, and 100h may be used as light emitting sources of various display devices. For example, the LEDs 100, 100a, 100b, 100c, 100d, 100e, 100f, 100g, and 100h may be applied to lighting devices or self-luminous display devices.

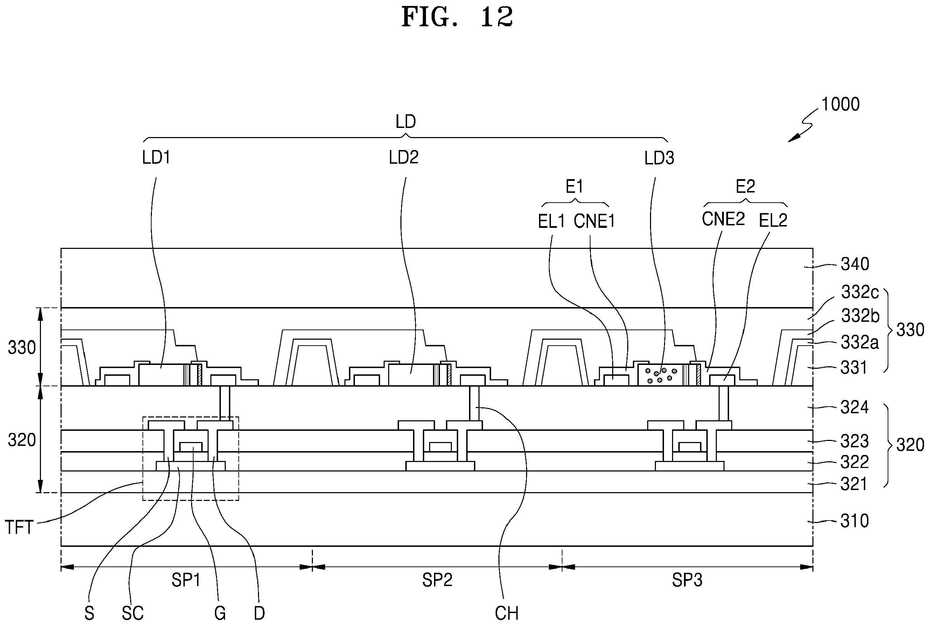

FIG. 12 is a diagram illustrating a part of a display device including a nitride semiconductor layer according to an embodiment. Referring to FIG. 12, a display apparatus 1000 may include a substrate 310 in which a plurality of pixels are provided. One pixel may include a first sub pixel SP1, a second sub pixel SP2, and a third sub pixel SP3 provided on the substrate 310.

The first to third sub pixels SP1, SP2, and SP3 may be a pixel region displaying an image in one pixel and may be a light emitting region from which light is emitted.

Each of the first to third sub pixels SP1, SP2, and SP3 may include a substrate 310, a driving device layer 320, a display device layer 330, and a cover structure layer 340.

The substrate 310 may include an insulating material such as glass, organic polymer, or quartz. In addition, the substrate 310 may be made of a material having flexibility so as to be bent or folded, and may have a single-layer structure or a multi-layer structure.

The driving device layer 320 may include a buffer layer 321 disposed on the substrate 310, a transistor TFT disposed on the buffer layer 321, and a driving voltage wiring (not shown).

The buffer layer 321 may prevent impurities from diffusing into the transistor TFT. The buffer layer 321 may be provided as a single layer, but may be provided as multiple layers equal to or more than at least a double layer.

When the buffer layer 321 is provided as multiple layers, each layer may be made of the same material or different materials. The buffer layer 321 may be omitted depending on the material and process conditions of the substrate 310.

The transistor TFT may drive the corresponding LED 100 among a plurality of LEDs LD1, LD2, and LD3 included in the display device layer 330. The transistor TFT may include a semiconductor layer SC, a gate electrode G, a source electrode S, and a drain electrode D.

The semiconductor layer SC may be disposed on the buffer layer 321. The semiconductor layer SC may include a source region in contact with the source electrode S and a drain region in contact with the drain electrode D. A region between the source region and the drain region may be a channel region.

The semiconductor layer SC may be a semiconductor pattern made of polysilicon, amorphous silicon, oxide semiconductor, etc. The channel region is a semiconductor pattern that is not doped with impurities, and may be an intrinsic semiconductor. The source region and the drain region may be semiconductor patterns doped with impurities.

The gate electrode G may be provided on the semiconductor layer SC with a gate insulating layer 322 disposed therebetween.

The source electrode S and the drain electrode D may respectively contact the source region and the drain region of the semiconductor layer SC through a contact hole penetrating an interlayer insulating layer 323 and a gate insulating layer 322.

A passivation layer 324 may be provided on the transistor TFT.

The display device layer 330 may include the plurality of LEDs LD1, LD2, and LD3 provided on the passivation layer 324. The LED LD1 in the first sub pixel SP1 may emit blue light, the LED LD2 in the second sub pixel SP2 may emit green light, and the LED LD3 in the third sub pixel SP3 may emit red light. For example, the LED LD1 may emit light of a wavelength of about 420 nm to about 495 nm, the LED LD2 in the second sub pixel SP2 may emit light of a wavelength of about 495 nm to about 570 nm, and the LED LD3 in the third sub pixel SP3 may emit light of a wavelength of about 620 nm to about 750 nm. However, the disclosure is not limited thereto. At least one of the plurality of LEDs LD1, LD2, and LD3 may emit light of a wavelength of about 380 nm to about 450 nm, light of a wavelength of about 570 nm to about 590 nm or light of a wavelength of about 590 nm to about 620 nm.

At least two of the LEDs LD1, LD2, and LD3 may include an active layer that generates light of the same wavelength. For example, an active layer included in the LED LD1 in the first sub pixel SP1 and an active layer included in the LED LD3 in the third sub pixel SP3 may generate blue light. In addition, QDs included in the LED LD3 of the third sub pixel SP3 may convert blue light into red light.

In the drawing, the LED LD3 in the third sub pixel SP3 is illustrated as the LED 100 of FIG. 1. However, the disclosure is not limited thereto. The LED LD3 may have structures of the above-described LEDs 100, 100a, 100c, 100d, 100e, 100f, 100g, and 100h. In addition, the LED LD2 in the second sub pixel SP2 may also have the structures of the above-described LEDs 100, 100a, 100c, 100d, 100e, 100f, 100g, and 100h.

The display device layer 330 may further include a pixel defining layer 331. The pixel defining layer 331 may be provided on the passivation layer 324, and may partition a light emitting region in each of the first to third sub pixels SP1, SP2, and SP3. The pixel defining layer 331 may include an opening exposing the LEDs LD1, LD2, and LD3 respectively included in the first to third sub pixels SP1, SP2, and SP3.

The two pixel defining layers 331 adjacent to each other on the substrate 310 may be spaced apart from each other by a predetermined space. For example, the two pixel defining layers 331 adjacent to each other may be spaced apart from each other on the substrate 210 by more than the length of the LEDs LD1, LD2, and LD3. The pixel defining layer 331 may be an insulating material including an inorganic material or an organic material, but is not limited thereto.

The pixel defining layer 331 may be an insulating material including an organic material. For example, the pixel defining layer 331 may include polystyrene, polymethylmethacrylate (PMMA), polyacrylonitrile (PAN), polyamide (PA), polyimide (PI), polyarylether (PAE), heterocyclic polymer, parylene, epoxy, benzocyclobutene (BCB), siloxane based resin, silane based resin, etc.

A first insulating layer 332a may be provided on the pixel defining layer 331. The first insulating layer 332a may cover a part of the upper surface of each of the LEDs LD1, LD2, and LD3 respectively provided in the first to third sub pixels SP1, SP2, and SP3. Due to the first insulating layer 332a, a first end and a second end of each of the LEDs LD1, LD2, and LD3 may be exposed to the outside.

First and second electrodes E1 and E2 may be disposed on the passivation layer 324. The first electrode E1 may include a first sub electrode EL1 disposed adjacent to one end (e.g., the first type semiconductor layer 11) of the corresponding LED LD, and a first contact electrode CNE1 electrically connecting the first sub electrode EL1 to one end of the light emitting diode LD. The second electrode E2 may include a second sub electrode EL2 disposed adjacent to the other end (e.g., the second type semiconductor layer 13) of the corresponding LED LD and a second contact electrode CNE2 electrically connecting the second sub electrode EL2 to one end of the LED LD. The first and second contact electrodes CNE1 and CNE2 may respectively correspond to the first and second electrodes 220 and 230 of FIG. 2.

Accordingly, the driving voltage may be applied to the corresponding LED LD through the first electrode E1 and the voltage of the transistor TFT may be applied to the corresponding LED LD through the second electrode E2. As a result, as a certain voltage is applied to both ends of the LED LD through the first electrode E1 and the second electrode E2, and thus, the LED LD may emit light.

A second insulating layer 332b and a third insulating layer 332c may be provided on the first and second electrodes E1 and E2.

An overcoat layer 340 may be provided on the third insulating layer 332c. The overcoat layer 340 may be a planarization layer 150 that alleviates a step difference caused by the components disposed therebelow. In addition, the overcoat layer 340 may be an encapsulation layer that prevents oxygen and moisture from penetrating into the LED 100.

In the display device 1000 of FIG. 12, the plurality of LEDs LD1, LD2, and LD3 emit light of different wavelengths of the corresponding sub pixels, and thus, a color conversion layer may not be required.

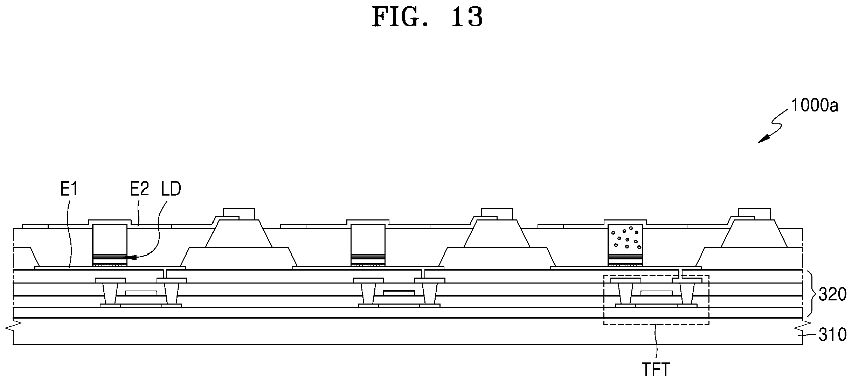

FIG. 13 is a diagram illustrating a part of a display apparatus 1000a according to another embodiment. Upon comparing FIGS. 12 and 13, the first type semiconductor layer 11, the active layer 12, and the second type semiconductor layer 13 of the LED LD shown in FIG. 13 may be arranged sequentially in the thickness direction of the substrate 310.

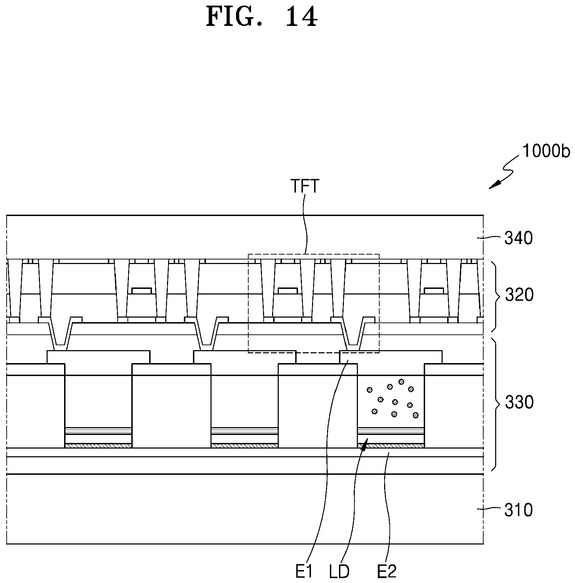

FIG. 14 is a diagram illustrating a part of a display apparatus 1000b according to another embodiment. As shown in FIG. 14, the display device layer 330, the driving device layer 320, and the overcoat layer 340 may be sequentially arranged on the substrate 310. Upon comparing FIGS. 13 and 14, the display device layer 330 may be disposed between the substrate 310 and the driving device layer 320. The display device 100b of FIG. 14 may be implemented as a bottom emission type by emitting light of different wavelengths from the LED LD.

The above-described display devices may be applied to various electronic devices having a screen display function.

The LED, the light emitting device including the LED, the display device, and a manufacturing method thereof described above have been described with reference to the embodiments shown in the drawings, but these are merely exemplary, and it will be understood by those of ordinary skill in the art that various modifications and other equivalent embodiments are possible therefrom. Although many matters have been specifically described above, they should be construed as examples of specific embodiments rather than limiting the scope of the disclosure. Therefore, the scope of the disclosure should not be defined by the described embodiments, but should be defined by the technical idea described in the claims and their equivalents.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims and their equivalents.

## Claims

1. A light emitting device comprising:
a light emitting rod including a porous first type semiconductor layer, an active layer, and a second type semiconductor layer which are sequentially arranged; and
a wavelength conversion cluster embedded in the porous first type semiconductor layer, the wavelength conversion cluster being configured to convert a first light generated in the active layer into a second light having a different wavelength.

2. The light emitting device of claim 1, wherein
the wavelength conversion cluster includes quantum dots converting the first light into the second light, and
the quantum dots are disposed in pores included in the porous first type semiconductor layer.

3. The light emitting device of claim 2, wherein a proportion of the quantum dots in the pores is equal to or greater than 80% of space in the pores.

4. The light emitting device of any preceding claim, further comprising: a wavelength selective transmission layer disposed on a side surface of the light emitting rod, the wavelength selective transmission layer being configured to reflect incident first light to the light emitting rod, and transmit incident second light to outside of the light emitting rod, and optionally wherein the wavelength selective transmission layer includes a distributed Bragg reflector.

5. The light emitting device of any preceding claim, further comprising: a reflective layer disposed on at least one of an upper surface or a lower surface of the light emitting rod, the reflective layer being configured to reflect the first light and the second light to the light emitting rod, and optionally wherein the reflective layer includes a conductive material.

6. The light emitting device of claim 5, wherein the reflective layer includes a metal material.

7. The light emitting device of any preceding claim, further comprising: a wavelength conversion layer disposed on a side surface of the light emitting rod and configured to convert the first light into the second light.

8. The light emitting device of any preceding claim, wherein a volume of the porous first type semiconductor layer is greater than at least one of: a volume of the active layer and a volume of the second type semiconductor layer.

9. The light emitting device of any preceding claim, wherein
the porous first type semiconductor layer includes an n-type semiconductor material, and
the second type semiconductor layer includes a p-type semiconductor material.

10. The light emitting device of any preceding claim, wherein the second light has a longer wavelength than a wavelength of the first light.

11. The light emitting device of any preceding claim, wherein a wavelength of the first light is equal to or greater than 300 nm and equal to or less than 500 nm.

12. The light emitting device of any preceding claim, wherein a wavelength of the second light is equal to or greater than 490 nm and equal to or less than 780 nm.

13. The light emitting device of any preceding claim, wherein the wavelength conversion cluster is further embedded in at least one of the active layer the second type semiconductor layer.

14. The light emitting device of any preceding claim, further comprising:
a first electrode electrically connected to the porous first type semiconductor layer; and
a second electrode electrically connected to the second type semiconductor layer,
wherein at least one of: the first electrode and the second electrode is a reflective electrode.

15. A manufacturing method of a light emitting device, the method comprising:
sequentially forming a first type semiconductor layer, an active layer, and a second type semiconductor layer on a substrate;
making the first type semiconductor layer porous; and
forming a wavelength conversion cluster comprising quantum dots in the porous first type semiconductor layer.
